# EUROPÄISCHE PATENTSCHRIFT

(11) **EP 2 483 700 B1**
(45) Veröffentlichungstag und Bekanntmachung des Hinweises auf die Patenterteilung: **21.12.2016**
(21) Anmeldenummer: 10757092.1
(22) Anmeldetag: 22.09.2010
(51) Int. Cl.: G01R 31/28

(54) **VORRICHTUNG ZUR KONDITIONIERUNG VON HALBLEITERCHIPS UND TESTVERFAHREN UNTER VERWENDUNG DER VORRICHTUNG**
APPARATUS FOR CONDITIONING SEMICONDUCTOR CHIPS AND TEST METHOD USING THE APPARATUS
DISPOSITIF POUR LE PRÉTRAITEMENT DE PUCES À SEMI-CONDUCTEURS ET PROCÉDÉ DE TEST AVEC UTILISATION DU DISPOSITIF

(30) Priorität: 02.10.2009 DE 102009045291
(43) Veröffentlichungstag der Anmeldung: 08.08.2012
(73) Patentinhaber: ERS Electronic GmbH, 82110 Germering (DE)
(72) Erfinder: REITINGER, Klemens, 82319 Starnberg (DE)
(74) Vertreter: Isarpatent
(86) Internationale Anmeldenummer: PCT/EP2010/063975
(87) Internationale Veröffentlichungsnummer: WO 2011/039087

(56) Entgegenhaltungen:
- WO-A1-99/18447
- WO-A2-99/38209
- WO-A2-2009/046884
- DE-A1-102006 036 291
- US-A- 5 172 049
- US-A- 5 907 246
- US-A1- 2005 225 346
- US-A1- 2006 244 472

## Beschreibung

Die vorliegende Erfindung betrifft eine Vorrichtung zur Konditionierung von Halbleiterchips und ein Testverfahren unter Verwendung der Vorrichtung.

Aus der WO99/38209 ist eine Vorrichtung zur Konditionierung von Halbleiterchips mit einer Chip-Temperierungseinrichtung zur Aufnahme eines oder einer Mehrzahl von Halbleiterchips bekannt, die einen Grundkörper aufweist, der von einem Fluid zur Temperierung durchspülbar ist und der eine entsprechende Anzahl von Ausnehmungen aufweist, die sich von einer Vorderseite zu einer Rückseite des Grundkörpers erstrecken. Eine entsprechende Anzahl von Chip-Kontaktsockeln ist vorgesehen, die in die Ausnehmung in thermischem Kontakt mit dem Grundkörper eingebracht sind, die auf der Vorderseite einen Chip-Aufnahmebereich und die im Inneren eine Verdrahtungseinrichtung aufweisen, die zum Anschluss elektrischer Signale vom und/oder zum im Chip-Aufnahmebereich eingesetzten Halbleiterchip eingerichtet sind. Weiterhin weist die bekannte Vorrichtung eine Basisplatine auf, die an der Rückseite des Grundkörpers derart angebracht ist, dass die Verdrahtungseinrichtung der Chip-Kontaktsockel mit einer Verdrahtungseinrichtung der Basisplatine in elektrischer Verbindung steht, sowie einen Trägertisch, auf welchem der Grundkörper und die daran angebrachte Basisplatine befestigt sind. Der Trägertisch ist zum Entladen und Beladen der Halbleiterchips verfahrbar.

Die DE 195 37 358 A1 offenbart Chip-Halteeinrichtungen, welche Verriegelungsglieder aufweisen, die unter Ausnutzung der Elastizität des Kunststoffmaterials, aus welchem ihr Trägerkörper besteht, auseinander gespreizt werden können, um Halbleiterchips zu beladen oder zu entlanden.

Die US 2006/0043990 A1 offenbart Chip-Halteeinrichtungen, bei denen ein Halbleiterchip in einem Aufnahmebereich eines Chip-Kontaktsockels gesetzt wird und anschließend eine Halteeinrichtung von der Unterseite des Chip-Kontaktsockels auf die Halbleiterchip aufgedrückt wird.

Bekannterweise werden Testmessungen an Halbleiterchips typischerweise in einem Temperaturbereich zwischen -200°C und +400°C durchgeführt. Zur Temperierung wird ein Halbleiterchip auf einen Kontaktierungssockel gelegt, über den er an eine elektronische Testvorrichtung angeschlossen wird, und dieser Kontaktierungssockel wird zusammen mit dem Halbleiterchip in einer Klimakammer entsprechend der Soll-Temperatur gekühlt und/oder beheizt und getestet. Dabei ist darauf zu achten, dass die Temperatur des Halbleiterchips nicht unter den Taupunkt des umgebenden gasförmigen Mediums gerät, da sonst eine Kondensation von Feuchtigkeit auf der Chipoberfläche bzw. eine Vereisung auftritt, welche die Testmessungen behindert bzw. unmöglich macht.

Aus der EP 1 495 486 B1 ist ein Verfahren zur Konditionierung von Halbleiterwafern bekannt, welches folgende Schritte aufweist: Bereitstellen eines zumindest teilweise geschlossenen Raums mit einem darin befindlichen Chuck zur Aufnahme eines Halbleiterwafers und Leiten eines trockenen Fluids durch den Chuck zum Temperieren des Wafers, wobei zumindest ein Teil des den Chuck verlassenden Fluids zum Konditionieren der Atmosphäre innerhalb des Raums verwendet wird.

Als nachteilhaft bei bekannten Vorrichtungen zum Konditionieren von Halbleiterchips hat sich die Tatsache herausgestellt, dass das Beladen und Entladen der Klimakammer zeitaufwendig ist, Betauungsprobleme auftreten und es nicht möglich ist, eine Vielzahl von Chips mit hohem Durchsatz zu testen.

Daher ist es Aufgabe der vorliegenden Erfindung, eine verbesserte Vorrichtung zur Konditionierung von Halbleiterchips und ein Testverfahren unter Verwendung der Vorrichtung anzugeben, welche eine effiziente Konditionierung und einen hohen Durchsatz bei erhöhter Flexibilität ermöglichen.

Das erfindungsgemäße Vorrichtung mit den Merkmalen des Anspruchs 1 bzw. das entsprechende Testverfahren nach Anspruch 8 weisen gegenüber dem bekannten Lösungsansatz den Vorteil auf, dass ein hoher Durchsatz und große Betriebssicherheit, insbesondere auch keine Betauungsprobleme, gewährleistet sind.

Die der vorliegenden Erfindung zugrundeliegende Idee besteht darin, dass eine Chip-Temperierungseinrichtung zur Aufnahme eines oder einer Mehrzahl von Halbleiterchips vorgesehen ist, die einen Grundkörper aufweist, der von einem Fluid zur Temperierung durchspülbar ist und der eine entsprechende Anzahl von Ausnehmungen aufweist, die sich von einer Vorderseite zu einer Rückseite des Grundkörpers erstrecken.

In die Ausnehmung bzw. Ausnehmungen vom Grundkörper ist jeweils ein Chip-Kontaktsockel eingebracht, der in thermischem Kontakt mit dem Grundkörper steht und der auf der Vorderseite einen Chipaufnahmebereich und der im Innern eine Verdrahtungseinrichtung aufweist, die zum Anschluss elektrischer Signale vom und/oder zum im Chipaufnahmebereich eingesetzten Halbleiterchip eingerichtet ist. Eine Basisplatine ist an der Rückseite des Grundkörpers derart angebracht, dass die Verdrahtungseinrichtung der Chip-Kontaktsockel mit einer Verdrahtungseinrichtung der Basisplatine in elektrischer Verbindung steht.

Somit ist einerseits eine gute thermische Anbindung der Halbleiterchips gewährleistet und andererseits eine hohe Flexibilität, da sich der bzw. die Chip-Kontaktsockel leicht auswechseln lassen und an beliebige Chipgeometrien bzw. Chipkontaktanordnungen anpassen lassen.

In den Unteransprüchen finden sich vorteilhafte Weiterbildungen und Verbesserungen des betreffenden Gegenstandes der Erfindung.

Ausführungsbeispiele der Erfindung sind in den Zeichnungen dargestellt und in der nachfolgenden Beschreibung näher erläutert.

Es zeigen:
- Fig. 1: eine schematische Darstellung einer ersten Ausführungsform der erfindungsgemäßen Konditionierungsvorrichtung;
- Fig. 2A: eine schematische Querschnittsdarstellung der ersten Temperierungseinrichtung der erfindungsgemäßen Konditionierungsvorrichtung gemäß Fig. 1 entlang der Linie X-X' bei eingesetzten Chips;
- Fig. 2B: eine schematische Querschnittsdarstellung der ersten Temperierungseinrichtung der erfindungsgemäßen Konditionierungsvorrichtung gemäß Fig. 1 entlang der Linie X-X' bei entfernten Chips;
- Fig. 3: eine Draufsicht der ersten Temperierungseinrichtung der erfindungsgemäßen Konditionierungsvorrichtung gemäß Fig. 1 bei entfernten Chips; und
- Fig. 4: eine schematische Vorderseitenansicht der Temperierungseinrichtungen, der Basisplatine und des Trägertisches zur Erläuterung einer zweiten Ausführungsform der erfindungsgemäßen Konditionierungsvorrichtung;
- Fig. 5: eine schematische Querschnittsdarstellung der ersten Temperierungseinrichtung gemäß einer weiteren Ausführungsform der erfindungsgemäßen Konditionierungsvorrichtung;
- Fig. 6: eine schematische Querschnittsdarstellung der ersten Temperierungseinrichtung gemäß noch einer weiteren Ausführungsform der erfindungsgemäßen Konditionierungsvorrichtung.

In den Figuren bezeichnen gleiche Bezugszeichen gleiche oder funktionsgleiche Bestandteile.

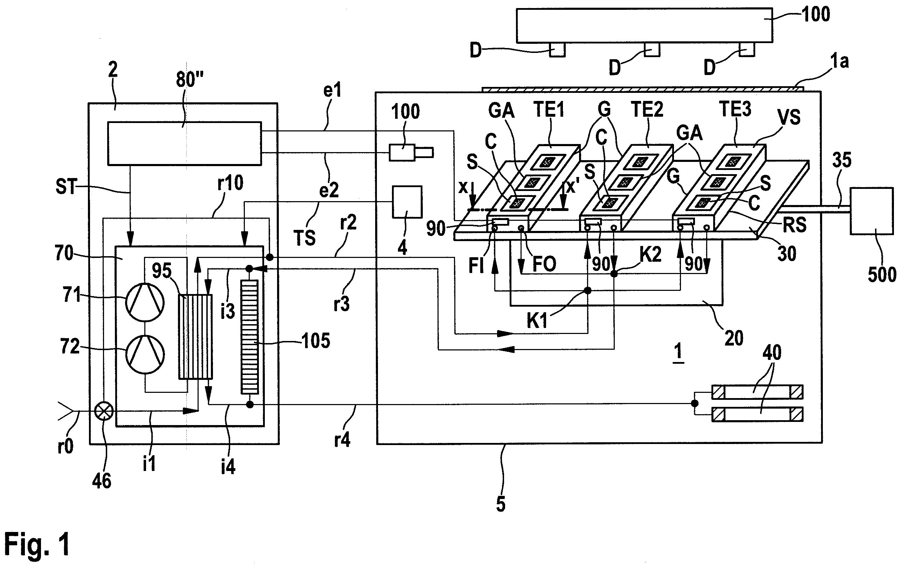

Fig. 1 zeigt eine schematische Darstellung einer ersten Ausführungsform der erfindungsgemäßen Konditionierungsvorrichtung

In Fig. 1 bezeichnet Bezugszeichen 1 einen Raum in einem Behälter 5, in dem eine Temperierungseinrichtung TE1, TE2, TE3 zur Aufnahme einer Mehrzahl von Halbleiterchips C Halbleiterchips C vorgesehen ist.

Die Chip-Temperierungseinrichtung TE1, TE2, TE3 besteht im gezeigten Beispiel aus drei identischen Modulen TE1, TE2, TE3, welche jeweils einen Grundkörper G, z.B. aus Edelstahl, aufweisen, der von einem Fluid zur Temperierung, z.B. getrockneter Luft, durchspülbar ist. Die Grundkörper G weisen jeweils eine Mehrzahl von Ausnehmungen GA auf, die sich von einer Vorderseite VS zu einer Rückseite RS des Grundkörpers G erstrecken.

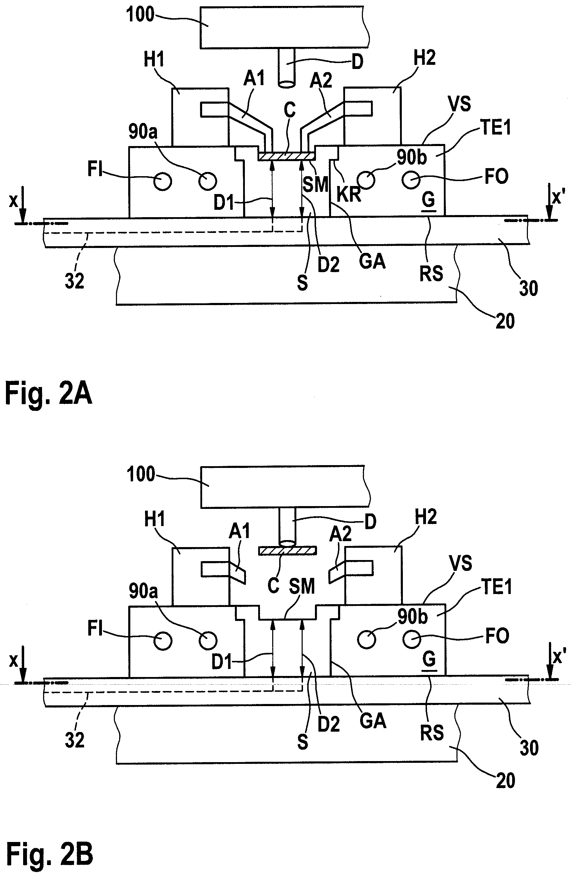

Eine Mehrzahl von Chip-Kontaktsockeln S, z.B. ebenfalls aus Edelstahl, ist jeweils in die Ausnehmungen GA in thermischem Kontakt mit dem Grundkörper G eingebracht. Die Chip-Kontaktsockel S weisen auf der Vorderseite VS einen Chipaufnahmebereich SM und im Innern eine isolierte Verdrahtungseinrichtung D1, D2 auf, die zum Anschluss elektrischer Signale vom und/oder zum im Chipaufnahmebereich SM eingesetzten Halbleiterchip C eingerichtet ist (vgl. Fig. 2A, B).

Eine Basisplatine 30 ist an der Rückseite RS des Grundkörpers G derart angebracht, dass die Verdrahtungseinrichtung D1, D2 der Chip-Kontaktsockel S mit einer Verdrahtungseinrichtung 32 der Basisplatine 30 in elektrischer Verbindung steht (vgl. Fig. 2A, B). Von der Verdrahtungseinrichtung 32 der Basisplatine 30 nach außerhalb des Behälters 5 geführt ist ein Flachbandkabel 35, welches mit einer Testvorrichtung 500 in Verbindung steht, welche die Testsignale generiert und die Antwortsignal des Halbleiterchips C auswertet.

Der Grundkörper G und die daran angebrachte Basisplatine 30 auf einem optional beweglichen Trägertisch 20 befestigt, der z.B. eine Verstellbarkeit in X-, Y- und Z-Richtung aufweist.

Der Behälter 5, dessen Volumen üblicherweise zwischen 1 und 10 Litern liegt, ist im wesentlichen geschlossenen und weist oberhalb der Chipaufnahmebereiche SM einen Deckel 1a, z.B. einen Schiebedeckel, auf, welcher zum Beladen und Entladen der Halbleiterchips C automatisch öffnungsfähig ist.

Eine Handlingvorrichtung 100, z.B. ein Roboter mit Ansauggreifern D, ist zum gleichzeitigen Beladen und Entladen der Halbleiterchips C vorgesehen. Mit anderen Worten können sämtliche Halbleiterchips im Rahmen eines einzigen Arbeitsschrittes des Roboters 100 beladen bzw. entladen werden.

Der Behälters 5 weist Durchführungen für elektrische Leitungen und Medienversorgungsleitungen sowie ggfs. Durchführungen für extern anzubringende Sonden aufweisen, mit denen die Testmessungen durchzuführen sind. Der Raum 1 muss durch den Behälter 5 allerdings abhängig vom Anwendungsfall nicht hermetisch abgeschlossen sein, muss aber zumindest soweit geschlossen, dass ein ungewünschtes Eindringen von feuchter Umgebungsluft durch Aufbau eines inneren Überdrucks verhindert werden kann.

Des weiteren ist in jeden Grundkörper G eine Heizeinrichtung 90 integriert, die über eine Leitung e1 von außen mit elektrischem Strom zum Heizen versorgt werden kann und die eine nicht gezeigte Temperatursonde aufweist.

Bezugszeichen 100 bezeichnet einen Taupunktsensor, mittels dem der Taupunkt innerhalb des Behälters 5 ermittelbar ist und die ein entsprechendes Signal über eine Leitung e2 nach außerhalb des Behälters 5 liefern kann. Der Taupunktsensor 100 dient insbesondere zur Sicherheit beim Öffnen des Geräts, damit z.B. ein Gegenheizen erfolgen kann, um eine Betauung zu vermeiden.

Weiterhin vorgesehen im Behälter sind Ausströmelemente 40 (oBdA. sind nur zwei gezeigt), über die von außerhalb über eine Leitung r4 getrocknete Luft oder ein ähnliches Fluid, wie z.B. Stickstoff, in den Behälter eingeführt werden kann, um feuchte Umgebungsluft aus dem Behälter 5 auszutreiben.

Eine separate Einheit, welche mit dem Behälter 5 über die elektrischen Leitungen e1, e2 und und Medienversorgungsleitung r2, r3, r4 verbunden ist, ist das Temperatursteuerrack 2, welches folgendermaßen aufgebaut ist.

Mit Bezugszeichen 80" ist ein Temperatur-Controller bezeichnet, der durch Beheizen der Heizeinrichtungen 90 die Temperatur des Grundkörpers G der Module der Chip-Temperierungseinrichtung TE1, TE2, TE3 regeln kann, wobei die Grundkörper G gleichzeitig oder alternativ mit dem Fluid in Form von getrockneter Luft zur Kühlung durchgespült werden, wie unten näher erläutert wird.

Der Temperatur-Controller 80" dient nicht nur zum Beheizen der Heizeinrichtung 90, sondern ist auch über die Leitung e2 mit dem Taupunktsensor 100 gekoppelt ist und kann somit ein automatisches Gegenheizen bei einer Betauungs-/ Vereisungsgefahr einleiten. Er steuert auch die Temperierungseinrichtung 70 über die Steuerleitung ST und übernimmt somit die Rolle einer Zentraltemperatursteuerung.

Bezugszeichen 70 bezeichnet eine Temperierungseinrichtung, der über die Leitungen r0 und i1 trockene Luft z.B. aus einer Gasflasche oder auch aus einem Lufttrockner zugeführt wird und die einen Wärmetauscher 95 aufweist, der mit Kühlaggregaten 71, 72 verbunden ist, durch die er auf eine vorbestimmte Temperatur bringbar ist.

Die über die Leitungen r0, i1 zugeführte trockene Luft wird durch den Wärmetauscher 95 geleitet und anschließend über die Versorgungsleitung r2 in den Behälter 5 zum Knotenpunkt K1 geführt, um von dort parallel in die Fluideingänge FI der Grundkörper geleitet zu werden, die sie durch entsprechende nicht gezeigte Kühlschlangen bzw. Kühlrohre durchqueren.

Parallel über Fluidausgänge FO der Grundkörper G, über den Knotenpunkt K2 und anschließend über die Leitung r3 verlässt die trockene Luft, welche die Grundkörper G gekühlt hat, dieselben und wird aus dem Behälter 5 heraus geleitet.

In der Temperierungseinrichtung 70 ist zusätzlich eine Heizeinrichtung 105 integriert, welche nicht in direktem Kontakt mit dem Wärmetauscher 95 steht. Die Leitung r3 ist zur Heizeinrichtung 105 geleitet, so dass die den Probertisch 10 über die Leitung r3 verlassende trockene Luft der Heizeinrichtung 105 im Temperatursteuerrack 2 zurückgeführt wird.

Ein Teil der über die Leitung r3 zurückgeführten trockenen Luft wird vor der Heizeinrichtung 105 über eine Leitung i3 abgezweigt und durch den Wärmetauscher 95 geleitet, wo sie genau so wie die frisch über die Leitungen r0, i1 zugeführte trockene Luft zur Abkühlung beiträgt. Den Wärmetauscher 95 verlässt die trockene Luft über die Leitung i4 und wird unmittelbar hinter der Heizeinrichtung 105 mit der Luft zusammengeführt, welche durch die Heizeinrichtung 105 geflossen ist. Vom entsprechenden Knotenpunkt wird diese trockene Luft über die Leitung r4 und die Ausströmelemente 40 in den Behälter 5 zur Konditionierung dessen Atmosphäre geleitet.

Bezugszeichen 4 bezeichnet einen Temperatursensor zur Erfassung der Temperatur im Raum 1, der ein entsprechendes Temperatursignal TS an die Temperierungseinrichtung 70 liefert, welches zur Regelung der Temperatur mittels der Heizeinrichtung 105 verwendet wird.

Weiterhin sieht diese Ausführungsform ein steuerbares Mischventil 46 und eine Bypassleitung r10 vor, durch die der Wärmetauscher 95 umgangen werden kann.

Durch diese Anordnung kann die getrocknete Luft eine Doppelfunktion erfüllen, nämlich zuerst die Kühlung der Grundkörper G und danach die Konditionierung der Atmosphäre des Raums 1, bevor sie durch Öffnungen des Behälters 5 wieder an die Umgebungsatmosphäre geführt wird, und somit effektiver verwendet werden. Ein besonderer Vorteil ist, dass eine "Restkälte" der getrockneten Luft, welche von den Grundkörpern G zurückfließt, zur Abkühlung des Wärmetauschers 95 genutzt werden kann und gleichzeitig erwärmt in den Behälter 5 zurückgeführt werden kann.

Fig. 2A ist eine schematische Querschnittsdarstellung der ersten Temperierungseinrichtung der erfindungsgemäßen Konditionierungsvorrichtung gemäß Fig. 1 entlang der Linie X-X' bei eingesetzten Chips, und Fig. 2B ist eine schematische Querschnittsdarstellung der ersten Temperierungseinrichtung der erfindungsgemäßen Konditionierungsvorrichtung gemäß Fig. 1 entlang der Linie X-X' bei entfernten Chips.

Wie in Fig. 2A dargestellt, weist der Grundkörper G einen rechteckigen Querschnitt auf, wobei etwa in der Mitte die Aussparungen GA vorgesehen sind, welche sich von seiner Vorderseite VS bis zu seiner Rückseite RS erstrecken. Stirnseitig erkennbar sind die Fluideinlassöffnung FI und die Fluidauslassöffnung FO, welche zu bzw. von dem inneren Kühlleitungslabyrinth laufen. 90a bezeichnet einen Eingang für die Heizeinrichtung 90, 90b einen entsprechenden Ausgang, wobei die Heizeinrichtung 90 üblicherweise in Form eines eingebetteten Widerstands vorgesehen ist. Die Chip-Kontaktsockel S weisen einen annähernd quadratischen Querschnitt auf und sind in die Aussparungen GA von oben her eingesetzt, wobei ein Kragen KR für einen guten Passsitz sorgt. Durch einen Formschluss der Chip-Kontaktsockel S mit dem Grundkörper G wird eine optimale thermische Anbindung gewährleistet. Insbesondere wird diese thermische Anbindung dadurch verstärkt, dass sowohl der Grundkörper G als auch die Chip-Kontaktsockel S aus demselben Material, hier Edelstahl, hergestellt sind. Zusätzlich vorgesehen sein kann eine (hier nicht dargestellte) Verschraubung der Chip-Kontaktsockel S mit dem Grundkörper G, welcher sich beispielsweise im Bereich des Kragens KR befindet. Der Chipaufnahmebereich SM befindet sich in der Mitte der Chip-Kontaktsockel S und ist gegenüber der Vorderseite VS des Grundkörpers G abgesenkt. Auf der zu kontaktierenden Seite des Halbleiterchips C, welche dem Chip-Kontaktsockel S zugewandt ist, befinden sich (nicht gezeigte) Kontaktflächen, die mit der im Inneren des Chip-Kontaktsockels S vorgesehenen Verdrahtungseinrichtung D1, D2 in Verbindung stehen.

Die Verdrahtungseinrichtung D1, D2 endet an der Oberseite des Chip-Kontaktsockels S, vorzugsweise mit kleinen hervorstehenden Stiften, welche mit den Kontaktflächen des Halbleiterchips C unmittelbar in Kontakt treten und somit für eine gute elektrische Verbindung in Form von Sondennadeln sorgen.

Auf der Vorderseite VS des Grundkörpers G vorgesehen neben den Chip-Kontaktsockeln S sind jeweilige Chip-Halteeinrichtungen H1, H2 (aus Übersichtlichkeitsgründen nicht in Fig. gezeigt), welche pneumatisch betätigbar sind, einen jeweiligen Halbleiterchip C im zugehörigen Chipaufnahmebereich SM zu halten, indem sie ihn nach unten drücken. Dazu weisen die Chip-Halteeinrichtungen H1, H2 pneumatisch betätigbare Haltearme A1, A2 auf, welche in Fig. 2A im Zustand mit eingesetztem Halbleiterchip C und in Fig. 2B im Zustand mit entferntem Halbleiterchip C gezeigt sind. Insbesondere werden gemäß Fig. 2B die Haltearme A1, A2 bei entferntem Halbleiterchip C, der sich gemäß Fig. 2B an dem Ansauggreifer D der Handlingvorrichtung 100 befindet, nicht nur vertikal angehoben, sondern auch lateral verdreht, um ein ungestörtes Abheben bzw. Aufsetzen der Halbleiterchips C zu ermöglichen.

Ebenfalls gut erkennbar in Fig. 2A, 2B ist die Anbindung der Verdrahtungseinrichtung D1, D2 an eine Verdrahtungseinrichtung 32, die in der bzw. auf der Basisplatine 32 vorgesehen ist, und welche gemäß Fig. 1 mit dem Flachbandkabel 35 verbunden ist.

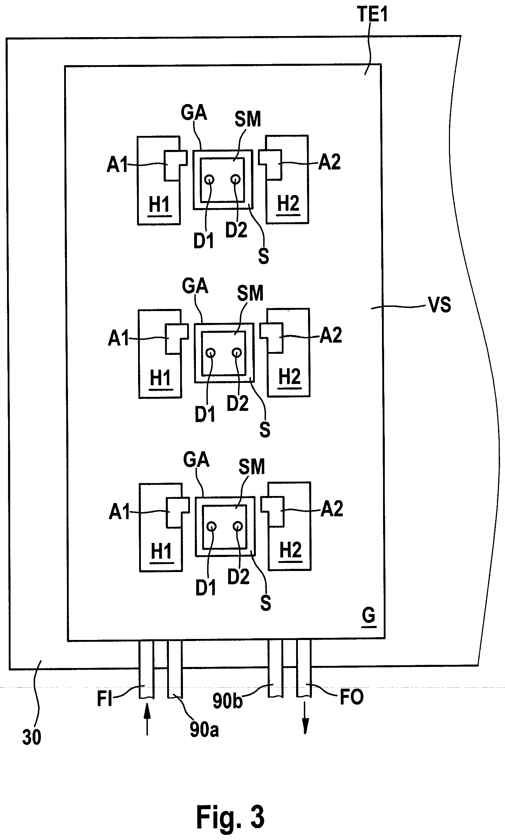

Fig. 3 ist eine Draufsicht der ersten Temperierungseinrichtung der erfindungsgemäßen Konditionierungsvorrichtung gemäß Fig. 1 bei entfernten Chips.

Wie aus Fig. 3 erkennbar, weist der Grundkörper G auch in der Draufsicht eine rechteckige Form auf. Ebenfalls erkennbar in Fig. 3 sind die nadelsondenartigen Oberenden der Verdrahtungseinrichtung D1, D2.

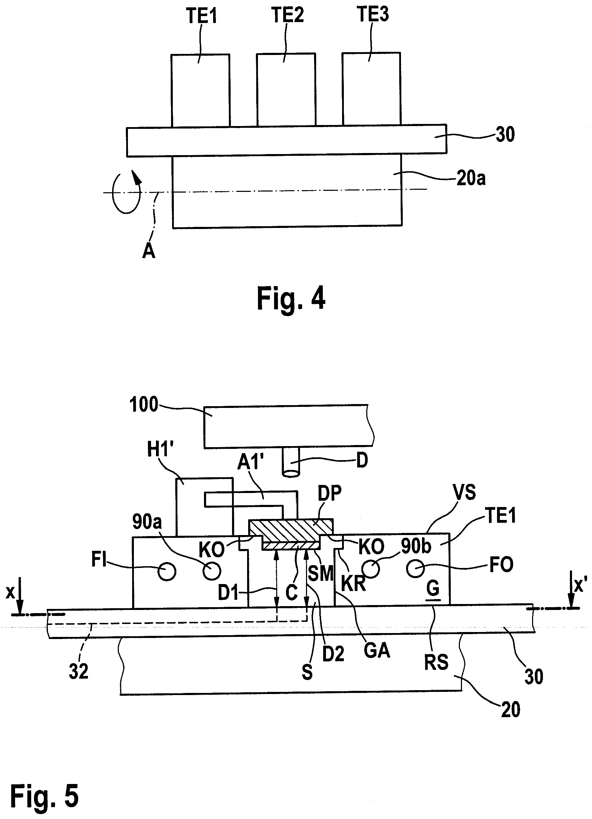

Fig. 4 ist eine schematische Vorderseitenansicht der Temperierungseinrichtungen, der Basisplatine und des Trägertisches zur Erläuterung einer zweiten Ausführungsform der erfindungsgemäßen Konditionierungsvorrichtung.

Bei der in Fig. 4 gezeigten zweiten Ausführungsform ist der Trägertisch 20a, auf dem die Basisplatine 30 mit den Temperierungseinrichtungen TE1, TE2, TE3 vorgesehen ist, um eine Achse A drehbar, sodass Testmessungen bei verschiedenen Winkelstellungen der Halbleiterchips C möglich sind. Eine derartige winkelabhängige Messung von Halbleiterchips C ist insbesondere bei Beschleunigungssensoren in MEMS-Technologie notwendig, um die Chipsignale kalibrieren zu können.

Fig. 5 zeigt eine schematische Querschnittsdarstellung der ersten Temperierungseinrichtung gemäß einer weiteren Ausführungsform der erfindungsgemäßen Konditionierungsvorrichtung.

Fig. 5 ist eine analoge Darstellung zu Fig. 2A, wobei Bezugszeichen H1' eine modifizierte Chip-Halteeinrichtung bezeichnet. Die Chip-Halteeinrichtung H1' weist einen Haltearm A1' auf, an dessen Ende eine Abdeckplatte DP aus Edelstahl vorgesehen ist. Die Abdeckplatte DP kann bei dem im Chip-Aufnahmebereich SM eingesetzten Halbleiterchip C derart aufgebracht werden, dass sie einerseits in thermischem Kontakt mit dem Halbleiterchip C und andererseits in thermischem Kontakt mit dem Kontaktsockel S steht, wobei die Kontaktbereiche zwischen der Abdeckplatte DP und dem Chip-Kontaktsockel S mit dem Bezugszeichen KO gekennzeichnet sind.

Diese Ausführungsform hat den Vorteil, dass eine noch bessere thermische Anbindung des Chips gewährleistet ist. Vorzugsweise überdeckt dabei die Abdeckplatte DP die gesamte Chipoberfläche.

Zum Entfernen des Halbleiterchips C wird die Abdeckplatte DP vom Haltearm A1' emporgehoben und seitlich weggedreht.

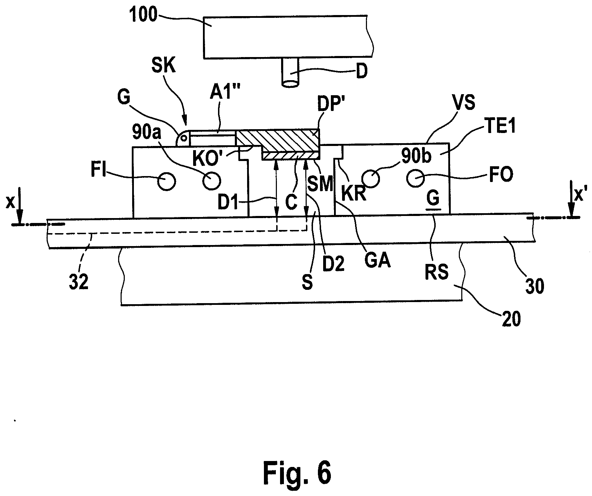

Fig. 6 zeigt eine schematische Querschnittsdarstellung der ersten Temperierungseinrichtung gemäß noch einer weiteren Ausführungsform der erfindungsgemäßen Konditionierungsvorrichtung.

Fig. 6 ist eine analoge Darstellung zu Fig. 2A, wobei bei dieser Ausführungsform ebenfalls eine Deckplatte DP' aus Edelstahl vorgesehen ist, welche in thermischem Kontakt mit dem Halbleiterchip C und dem Chip-Kontaktsockel S und dem Grundkörper G steht, wobei der Kontaktbereich zur Temperierungseinrichtung TE1 mit dem Bezugszeichen KO' gekennzeichnet ist. Die Abdeckplatte DP' ist über den Haltearm A1" mit einer Gelenkeinrichtung G verbunden, welche über ein Steuersignal SK pneumatisch, elektrisch oder mechanisch steuerbar ist.

Beim Betrieb der geschilderten Ausführungsformen der erfindungsgemäßen Konditionierungsvorrichtung gemäß Fig. 1 bis 6 erfolgt ein automatisches Einbringen einer Mehrzahl von Halbleiterchips C in die Chipaufnahmebereiche SM der Chip-Temperierungseinrichtung TE1, TE2, TE3 mittels der Handlingvorrichtung 100, wobei der Deckel 1a des Behälters 5 geöffnet ist.

Anschließend wird der Deckel 1a des Behälters 5 geschlossen, und es erfolgt ein Temperieren der Chip-Temperierungseinrichtung TE1, TE2, TE3 auf eine vorgegebene Messtemperatur, z. B. -40° C. Ist die Messtemperatur erreicht, so werden elektrische Signale von der Testvorrichtung 500 vom und/oder zum im Chipaufnahmebereich SM eingesetzten Halbleiterchip C gemäß einer gewünschten Testprozedur geleitet.

Nach Beendigung der Messungen wird der Deckel 1a geöffnet, wobei dafür gesorgt ist, dass im Behälter 5 durch die aus den Ausströmelementen 40 ausströmende getrocknete Luft ein Überdruck herrscht, sodass die Temperierungseinrichtungen TE1, TE2, TE3 auf niedriger Temperatur belassen werden können, ohne dabei zu vereisen.

Nach einem automatischen Ausbringen der Mehrzahl von Halbleiterchips C aus den Chipaufnahmebereichen SM der Chip-Kontaktsockel S, kann ein erneutes Beladen usw. stattfinden.

Obwohl die vorliegende Erfindung vorstehend anhand bevorzugter Ausführungsbeispiele beschrieben wurde, ist sie darauf nicht beschränkt, sondern auf vielfältige Weise modifizierbar. Obwohl bei den oben gezeigten Ausführungsformen eine Halteeinrichtung für die Halbleiterchips vorgesehen ist, um diese insbesondere bei Messungen mit verschiedener Winkelstellung in den Chipaufnahmebereichen zu halten, ist dies nicht zwingend erforderlich, insbesondere, wenn lediglich eine Messung im waagrechten Zustand vorgesehen ist. Auch kann die Halteeinrichtung nicht nur in Form einer pneumatischen Halteeinrichtung vorgesehen werden, sondern auch elektrisch oder elektro-mechanisch implementiert werden.

Die dargestellte Geometrie der Grundkörper und der Chip-Kontaktsockel ist ebenfalls nur beispielhaft und kann in vielfacher Weise variiert werden. Auch die Anzahl der Module der Temperierungseinrichtung ist anwendungsspezifisch wählbar.

## Patentansprüche

1. Vorrichtung zur Konditionierung von Halbleiterchips, mit:
einer Chip-Temperierungseinrichtung (TE1, TE2, TE3) zur Aufnahme eines oder einer Mehrzahl von Halbleiterchips (C), die einen Grundkörper (G) aufweist, der von einem Fluid zur Temperierung durchspülbar ist und der eine entsprechende Anzahl von Ausnehmungen (GA) aufweist, die sich von einer Vorderseite (VS) zu einer Rückseite (RS) des Grundkörpers (G) erstrecken;
einer entsprechenden Anzahl von Chip-Kontaktsockeln (S), die in die Ausnehmungen (GA) in thermischem Kontakt mit dem Grundkörper (G) eingebracht sind, die auf der Vorderseite (VS) einen Chipaufnahmebereich (SM) und die im Innern eine Verdrahtungseinrichtung (D1, D2) aufweisen, die zum Anschluss elektrischer Signale vom und/oder zum im Chipaufnahmebereich (SM) eingesetzten Halbleiterchip (C) eingerichtet ist;
einer Basisplatine (30), die an der Rückseite (RS) des Grundkörpers (G) derart angebracht ist, dass die Verdrahtungseinrichtung (D1, D2) der Chip-Kontaktsockel (S) mit einer Verdrahtungseinrichtung (32) der Basisplatine (30) in elektrischer Verbindung steht; und
einem Trägertisch (20a), auf welchem der Grundkörper (G) und die daran angebrachte Basisplatine (30) befestigt sind, und welcher um mindestens eine Achse (A) drehbar ist, so dass Testmessungen bei verschiedenen Winkelstellungen der Halbleiterchips (C) möglich sind;
wobei auf der Vorderseite (VS) des Grundkörpers (G) seitlich neben den Chip-Kontaktsockeln (S) jeweilige Chip-Halteeinrichtungen (H1, H2) vorgesehen sind, welche betätigbar sind, einen jeweiligen Halbleiterchip (C) im zugehörigen Chipaufnahmebereich (SM) zu halten,
wobei die Chip-Halteeinrichtungen (H1, H2) mechanisch, pneumatisch oder elektrisch betätigbare Haltearme (A1, A2; A1', A2'; A1", A2") aufweisen, welche zum Abheben und Aufsetzen der Halbleiterchips (C) gegenüber dem Grundkörper (G) vertikal anhebbar und lateral verdrehbar sind; und
wobei eine Handlingvorrichtung (100) zum gleichzeitigen Beladen und Entladen der Halbleiterchips (C) vorgesehen ist.

2. Vorrichtung nach Anspruch 1, wobei
die Chip-Temperierungseinrichtung (TE1, TE2, TE3) in einem im Wesentlichen geschlossenen Behälter (1) vorgesehen ist, der oberhalb der Chipaufnahmebereiche (SM) einen Deckel (1a) aufweist, welcher zum Beladen und Entladen der Halbleiterchips (C) öffnungsfähig ist.

3. Vorrichtung nach Anspruch 2, wobei
eine Leitungseinrichtung (r2, r3, r4, i3, i4) zum Leiten des Fluids von außerhalb des Behälters (1) in den Behälter (1) und durch die Chip-Temperierungseinrichtung (TE1, TE2, TE3) und zum Leiten zumindest ein Teil des die Chip-Temperierungseinrichtung (TE1, TE2, TE3) verlassenden Fluids in den Behälter (1) zum Konditionieren der Atmosphäre in dem Behälter (1) vorgesehen ist.

4. Vorrichtung nach Anspruch 3, wobei die Leitungseinrichtung (r2, r3, r4, i3, i4) aufweist:
eine erste Leitung (r2), über die das Fluid von außerhalb des Behälters (1) in den Behälter (1) und in die Chip-Temperierungseinrichtung (TE1, TE2, TE3) leitbar ist;
eine zweite Leitung (r3), über die das Fluid aus der Chip-Temperierungseinrichtung (TE1, TE2, TE3) nach ausserhalb des Raums (1) leitbar ist; und
eine dritte Leitung (r4), über die das den Behälter (1) verlassende Fluid von außerhalb des Behälters (1) in den Behälter (1) rückführbar ist;
wobei zwischen der zweiten und dritten Leitung (r3, r4) eine Temperierungseinrichtung (70) außerhalb des Behälters (1) vorgesehen ist.

5. Vorrichtung nach Anspruch 4, **dadurch gekennzeichnet, dass** am Ende der dritten Leitung (r4) Ausströmelemente (40) vorgesehen sind.

6. Vorrichtung nach einem der vorhergehenden Ansprüche, wobei an einem Ende der Haltearme (A1', A2'; A1", A2") eine jeweilige Abdeckplatte (DP; DP') vorgesehen ist, welche auf den jeweiligen im Chipaufnahmebereich (SM) eingesetzten Halbleiterchip (C) derart aufbringbar ist, dass sie in thermischen Kontakt mit dem Halbleiterchip (C) und dem Chip-Kontaktsockel (S) steht.

7. Vorrichtung nach Anspruch 6, wobei die Abdeckplatte (DP') über eine steuerbare Gelenkeinrichtung (G, A1") aufbringbar ist.

8. Verfahren zur Konditionierung von Halbleiterchips mittels einer Vorrichtung nach Anspruch 1, mit den Schritten:
automatisches gleichzeitiges Einbringen einer entsprechenden Anzahl von Halbleiterchips (C) in die Chipaufnahmebereiche (SM) der Chip-Temperierungseinrichtung (TE1, TE2, TE3) mittels der Handlingvorrichtung (100);
Betätigen der jeweiligen Chip-Halteeinrichtungen (H1, H2) zum Halten der jeweiligen Halbleiterchips (C) im zugehörigen Chipaufnahmebereich (SM), wobei die Haltearme (A1, A2; A1', A2'; A1", A2") gegenüber dem Grundkörper (G) vertikal angehoben und lateral verdreht werden;
Temperieren der Chip-Temperierungseinrichtung (TE1, TE2, TE3) auf eine vorgegebene Temperatur;
Leiten elektrischer Signale vom und/oder zum jeweiligen im Chipaufnahmebereich (SM) eingesetzten Halbleiterchip (C) bei der vorgegebenen Temperatur gemäß einer gewünschten Testprozedur bei zumindest zwei unterschiedlichen Drehpositionen des Trägertisches (20; 20a);
vertikales Anheben und laterales Verdrehen der Haltearme (A1, A2; A1', A2'; A1", A2"); und
automatisches gleichzeitiges Ausbringen der Halbleiterchips (C) aus den Chipaufnahmebereichen (SM) der Chip-Temperierungseinrichtung (TE1, TE2, TE3) mittels der Handlingvorrichtung (100).

9. Verfahren nach Anspruch 8, wobei die Chip-Temperierungseinrichtung (TE1, TE2, TE3) in einem im wesentlichen geschlossenen Behälter (1) vorgesehen ist, der oberhalb der Chipaufnahmebereiche (SM) einen Deckel (1a) aufweist, welcher zum Beladen und Entladen der Halbleiterchips (C) öffnungsfähig ist, mit den Schritten:
Erzeugen eines Überdrucks des Fluids in dem Behälter (1) bei geöffnetem Deckel.

10. Verfahren nach Anspruch 9, wobei der Überdruck dadurch erzeugt wird, dass zumindest ein Teil des die Chip-Temperierungseinrichtung (TE1, TE2, TE3) verlassenden Fluids in den Behälter (1) zum Konditionieren der Atmosphäre in dem Behälter (1) geleitet wird.

## Claims

1. Device for conditioning semiconductor chips, comprising:
a chip temperature control device (TE1, TE2, TE3) for receiving one or a plurality of semiconductor chips (C), which has a base body (G), which can be flushed through by a liquid for temperature control and has a corresponding number of recesses (GA) which extend from a front face (VS) to a rear face (RS) of the base body (G); a corresponding number of chip contact sockets (S) which are introduced into the recesses (GA) in thermal contact with the base body (G), which have a chip receiving region on the front face (VS) and which have a wiring device (D1, D2) in the interior which is set up to connect electrical signals from and/or to the semiconductor chip (C) inserted into the chip receiving region (SM);
a base circuit board (30), which is attached to the rear face (RS) of the base body (G) in such a way that the wiring device (D1, D2) of the chip contact socket (S) is in an electrical connection to a wiring device (32) of the base circuit board (30); and
a support table (20a), to which the base body (G) and the base circuit board (30) attached thereto are fixed, and
which is rotatable about at least one axis (A) in such a way that test measurements are possible in various angular positions of the semiconductor chips (C);
wherein chip holding devices (H1, H2) are provided on the front face (VS) of the base body (G), laterally alongside the respective chip contact sockets (S), and are each actuable to hold a semiconductor chip (C) in the associated chip receiving region (SM),
wherein the chip holding devices (H1, H2) have mechanically, pneumatically or electrically actuable holding arms (A1, A2; A1', A2; A1", A2"), which are can be vertically lifted and laterally rotated with respect to the base body (G) so as to lift up and set down the semiconductor chips (C); and
wherein a handling device (100) for simultaneously loading and unloading the semiconductor chips (C) is provided.

2. Device according to claim 1, wherein
the chip temperature control device (TE1, TE2, TE3) is provided in a substantially closed container (1), which has a cover (1a), which is openable for loading and unloading the semiconductor chips (C), above the chip receiving regions (SM).

3. Device according to claim 2, wherein
a channelling device (r2, r3, r4, i3, i4), for channelling the fluid from outside the container (1) into the container (1) and through the chip temperature control device (TE1, TE2, TE3) and for channelling at least part of the fluid leaving the chip temperature control device (TE1, TE2, TE3) into the container (1) to condition the atmosphere in the container (1), is provided.

4. Device according to claim 3, wherein the channelling device (r2, r3, r4, i3, i4) comprises:
a first line (r2) via which the fluid from outside the container (1) can be channelled into the container (1) and into the chip temperature control device (TE1, TE2, TE3) ;
a second line (r3) via which the fluid from the chip temperature control device (TE, TE2, TE3) can be channelled outside the space (1); and
a third line (r4), via which the fluid leaving the container (1) can be passed back from outside the container (1) into the container (1);
a temperature control device (70) being provided outside the container (1) between the second and the third line (r3, r4).

5. Device according to claim 4, **characterised in that** outlet elements (40) are provided at the end of the third line (r4).

6. Device according to any of the preceding claims, wherein a cover plate (DP; DP') is provided on an end of each of the holding arms (A1', A2'; A1", A2"), and can be attached to the associated semiconductor chip (C) inserted into the chip receiving region (SM) in such a way as to be in thermal contact with the semiconductor chip (C) and the chip contact socket (S).

7. Device according to claim 6, wherein the cover plate (DP') can be attached via a controllable articulation device (G, A1").

8. Method for conditioning semiconductor chips using a device according to claim 1, comprising the steps of:
automatically simultaneously introducing a corresponding number of semiconductor chips (C) into the chip receiving regions (SM) of the chip temperature control device (TE1, TE2, TE3) by means of the handling device (100);
actuating the respective chip holding devices (H1, H2) to hold the respective semiconductor chips (C) in the associated chip receiving regions (SM), the holding arms (A1, A2; A1', A2'; A1", A2") being vertically lifted and laterally rotated with respect to the base body (G);
temperature-controlling the chip temperature control device (TE1, TE2, TE3) to a predetermined temperature;
passing electrical signals from and/or to the semiconductor chip (C) inserted into each chip receiving region (SM) at the predetermined temperature in accordance with a desired test procedure in at least two different rotational positions of the support table (20; 20a) ;
vertically lifting and laterally rotating the holding arms (A1, A2; A1', A2'; A1", A2"); and
automatically simultaneously removing the semiconductor chips (C) from the chip receiving regions (SM) of the chip temperature control device (TE1, TE2, TE3) by means of the handling device (100).

9. Method according to claim 8, wherein the chip temperature control device (TE1, TE2, TE3) is provided in a substantially closed container (1), which has a cover (1a), which is openable for loading and unloading the semiconductor chips (C), above the chip receiving regions (SM), comprising the steps of:
generating an overpressure in the fluid in the container (1) when the cover is open.

10. Method according to claim 9, wherein the overpressure is generated by passing at least some of the fluid leaving the chip temperature control device (TE1, TE2, TE3) into the container (1) to condition the atmosphere in the container (1).

## Revendications

1. Dispositif de conditionnement de puces à semi-conducteur comprenant :
un moyen de régulation de température (TE1, TE2, TE3) de puces, destiné à récevoir une ou une pluralité de puces à semi-conducteur (C), lequel présente un corps de base (G) pouvant être traversé par un fluide de régulation de température et présentant un nombre correspondant d'évidements (GA) qui s'étendent d'une face avant (VS) vers une face arrière (RS) du corps de base (G) ;
un nombre correspondant de socles de contact (S) de puces, qui sont insérés dans les évidements (GA) en étant en contact thermique avec le corps de base (G), qui présentent sur la face avant (VS) une zone de réception (SM) de puce et qui, à l'intérieur, présentent un moyen de câblage (D1, D2) qui est agencé pour le raccordement de signaux électriques en provenance de et/ou allant vers la puce à semi-conducteur (C) insérée dans la zone de réception (SM) de puce ;
une platine de base (30) qui est placée au dos (RS) du corps de base (G) de manière à ce que le moyen de câblage (D1, D2) des socles de contact (S) de puces soit en liaison électrique avec un moyen de câblage (32) de la platine de base (30) ; et
une table porteuse (20a) sur laquelle sont fixés le corps de base (G) et la platine de base (30) qui y est rapportée, et laquelle est rotative autour d'au moins un axe (A) de sorte que des mesures de test sont possibles dans différentes positions angulaires des puces à semi-conducteur (C) ;
dans lequel des moyens respectifs de maintien (H1, H2) de puces sont ménagés sur la face avant (VS) du corps de base (G), latéralement à côté des socles de contact (S) de puces, lesquels sont actionnables pour maintenir une puce respective à semi-conducteur (C) dans la zone de réception (SM) de puce correspondante,
dans lequel les moyens de maintien (H1, H2) de puces présentent des bras de maintien (A1, A2 ; A1', A2' ; A1", A2") actionnables de manière mécanique,
pneumatique ou électrique, lesquels peuvent être soulevés verticalement et être tournés latéralement pour soulever et poser les puces à semi-conducteur (C) par rapport au corps de base (G) ; et
dans lequel un dispositif de manutention (100) est ménagé pour le chargement et le déchargement simultanés des puces à semi-conducteur (C).

2. Dispositif selon la revendication 1, dans lequel le moyen de régulation de température (TE1, TE2, TE3) de puces est ménagé dans un réservoir (1) essentiellement fermé, qui, au-dessus des zones de réception (SM) de puces, présente un couvercle (1a) lequel est apte à être ouvert pour le chargement et le déchargement des puces à semi-conducteur (C).

3. Dispositif selon la revendication 2, dans lequel un moyen de guidage (r2, r3, r4, i3, i4) destiné à guider le fluide dans le réservoir (1) et à travers le moyen de régulation de température (TE1, TE2, TE3) de puces depuis l'extérieur du réservoir (1) et destiné à guider dans le réservoir (1) au moins une partie du fluide sortant du moyen de régulation de température (TE1, TE2, TE3) de puces est ménagé dans le but du conditionnement de l'atmosphère dans le réservoir (1).

4. Dispositif selon la revendication 3, dans lequel le moyen de guidage (r2, r3, r4, i3, i4) présente :
une première conduite (r2) par l'intermédiaire de laquelle le fluide peut être guidé dans le réservoir (1) et dans le moyen de régulation de température (TE1, TE2,
TE3) de puces depuis l'extérieur du réservoir (1) ;' une deuxième conduite (r3) par l'intermédiaire de laquelle le fluide peut être guidé hors du moyen de régulation de température (TE1, TE2, TE3) de puces en direction allant vers l'extérieur de la pièce (1) ; et
une troisième conduite (r4) par l'intermédiaire de laquelle le fluide sortant du réservoir (1) peut être ramené en retour dans le réservoir (1) depuis l'extérieur du réservoir (1) ;
dans lequel un moyen de régulation de température (70) est ménagé à l'extérieur du réservoir (1) entre la deuxième et la troisième conduites (r3, r4).

5. Dispositif selon la revendication 4, **caractérisé en ce que** des éléments d'écoulement (40) sont ménagés à l'extrémité de la troisième conduite (r4).

6. Dispositif selon l'une quelconque des revendications précédentes, dans lequel une plaque de recouvrement (DP ; DP') respective est ménagée sur une extrémité des bras de maintien (A1', A2' ; A1", A2"), laquelle peut être appliquée sur la puce à semi-conducteur (C) insérée sur la zone respective de réception (SM) de puce de manière à ce qu'elle soit en contact thermique avec la puce à semi-conducteur (C) et le socle de contact (S) de puce.

7. Dispositif selon la revendication 6, dans lequel la plaque de recouvrement (DP') peut être appliquée par l'intermédiaire d'un moyen articulé (G, A1") commandable.

8. Procédé de conditionnement de puces à semi-conducteur au moyen d'un dispositif selon la revendication 1, comprenant les étapes :
insertion automatique simultanée d'un nombre correspondant de puces à semi-conducteur (C) dans les zones de réception (SM) de puces du moyen de régulation de température (TE1, TE2, TE3) de puces au moyen du dispositif de manutention (100) ;
actionnement des moyens respectifs de maintien de puces (H1, H2) destinés au maintien des puces respectives à semi-conducteur (C) dans la zone correspondante de réception (SM) de puce, dans lequel procédé les bras de maintien (A1, A2 ; A1', A2' ; A1", A2") sont soulevés verticalement et tournés latéralement par rapport au corps de base (G) ;
régulation de température du moyen de régulation de température (TE1, TE2, TE3) de puces à une température prédéfinie ;
guidage de signaux électriques en provenance de et/ou en direction allant vers la puce à semi-conducteur (C) respective insérée dans la zone de réception (SM) de puce à la température prédéfinie, selon une procédure de test souhaitée avec au moins deux positions de rotation différentes de la table porteuse (20 ; 20a) ;
soulèvement vertical et rotation latérale des bras de maintien (A1, A2 ; A1', A2' ; A1", A2"); et enlèvement automatique simultané des puces à semi-conducteur (C) hors des zones de réception (SM) de puces du moyen de régulation de température (TE1, TE2, TE3) de puces au moyen du dispositif de manutention (100).

9. Procédé selon la revendication 8, dans lequel le moyen de régulation de température (TE1, TE2, TE3) de puces est ménagé dans un réservoir (1) essentiellement fermé, qui présente un couvercle (1a) au-dessus des zones de réception (SM) de puces, lequel couvercle est apte à être ouvert pour le chargement et le déchargement des puces à semi-conducteur (C), comprenant les étapes :
création d'une surpression du fluide dans le réservoir (1) lorsque le couvercle est ouvert.

10. Procédé selon la revendication 9, dans lequel la surpression est créée du fait qu'au moins une partie du fluide sortant du moyen de régulation de température (TE1, TE2, TE3) de puces est guidé dans le réservoir (1) pour le contionnement de l'atmosphère dans le réservoir (1).
